# EUROPEAN PATENT APPLICATION

(11) **EP 4 560 637 A1**
(43) Date of publication of application: **28.05.2025**
(21) Application number: 24213234.8
(22) Date of filing: 15.11.2024
(51) Int. Cl.: G11C 11/406, G11C 5/02, G11C 5/04

(54) **MEMORY DEVICE PERFORMING REFRESH OPERATION AND OPERATION METHOD THEREOF**

(30) Priority: 27.11.2023 KR 20230167148; 21.03.2024 KR 20240039279
(71) Applicant: Samsung Electronics Co., Ltd., Suwon-si, Gyeonggi-do 16677 (KR)
(72) Inventor: BAEK, Seungbum, 16677 Suwon-si (KR); PARK, Sungcheol, 16677 Suwon-si (KR); KANG, Mingoo, 16677 Suwon-si (KR); KYUNG, Hyunmin, 16677 Suwon-si (KR); PARK, Sanghune, 16677 Suwon-si (KR); LEE, Juyeon, 16677 Suwon-si (KR)
(74) Representative: Marks & Clerk LLP

(57) **Abstract**

A memory device, including: a plurality of core dies, wherein each core die of the plurality of core dies includes a plurality of channel areas including a plurality of bank arrays, and wherein the plurality of core dies are stacked in a vertical direction; and a logic die below the plurality of core dies, wherein the logic die includes a memory controller and at least one temperature sensor configured to transmit data to the plurality of channel areas and to receive data from the plurality of channel areas using a plurality of channels, wherein the memory controller is configured to independently adjust refresh cycles of the plurality of bank arrays based on temperature values obtained from a plurality of first temperature sensors included in the plurality of channel areas and a second temperature sensor included in the logic die.

## Description

### BACKGROUND

### 1. Field

The disclosure relates to a memory device, and more particularly, to a memory device that adjusts a refresh cycle and an operation method thereof.

### 2. Description of Related Art

Dynamic random access memory (DRAM) may operate by recording data using charges stored in a cell capacitor. Due to the leakage current of the cell capacitor of the DRAM, the charge stored in the cell capacitor may disappear over time even when there are no read or write operations. The leakage current of DRAM may have a temperature dependence, decreasing at low temperatures and increasing at high temperatures. The DRAM may perform a refresh operation to sense and rewrite data before the cell capacitor loses charge due to leakage current. The DRAM may change a refresh operation so that a refresh cycle is set to be longer when the temperature is lower and to be shorter when the temperature is higher.

### SUMMARY

Provided is a memory device that independently performs a refresh operation on each of a plurality of bank arrays and an operation method thereof.

Additional aspects will be set forth in part in the description which follows and, in part, will be apparent from the description, or may be learned by practice of the presented embodiments.

In accordance with an aspect of the disclosure, a memory device includes: a plurality of core dies, wherein each core die of the plurality of core dies includes a plurality of channel areas including a plurality of bank arrays, and wherein the plurality of core dies are stacked in a vertical direction; and a logic die below the plurality of core dies, wherein the logic die includes a memory controller and at least one temperature sensor configured to transmit data to the plurality of channel areas and to receive data from the plurality of channel areas using a plurality of channels, wherein the memory controller is configured to independently adjust refresh cycles of the plurality of bank arrays based on temperature values obtained from a plurality of first temperature sensors included in the plurality of channel areas and a second temperature sensor included in the logic die. The memory controller may independently adjust refresh adjust refresh cycles of the plurality of bank arrays based only on temperature values obtained from a plurality of first temperature sensors included in the plurality of channel areas and a second temperature sensor included in the logic die.

In accordance with an aspect of the disclosure, an operation method of a memory device includes: obtaining a plurality of first temperature values from a plurality of first temperature sensors included in a plurality of vertically stacked core dies; obtaining a second temperature value from a second temperature sensor included in a logic die below the plurality of core dies; estimating temperature values corresponding to a plurality of bank arrays included in the plurality of core dies, based on the first temperature values and the second temperature value; and based on the estimated temperature values, independently updating refresh cycles of a plurality of bank arrays included in each core die from among the plurality of core dies. The method may be a method of operating a memory device. The method may include based only on the estimated temperature values, independently updating refresh cycles of a plurality of bank arrays included in each core die from among the plurality of core dies.

In accordance with an aspect of the disclosure, a semiconductor device includes: an interposer including conductive materials; a stacked memory device on the interposer, wherein the stacked memory device includes a plurality of core dies and a buffer die, wherein the plurality of core dies includes a plurality of bank arrays and a plurality of first temperature sensors, and wherein the buffer die includes a first interface circuit and a second temperature sensor; and a system-on-chip on the interposer, wherein the system-on-chip includes a second interface circuit and a memory controller, wherein the second interface circuit is configured to communicate with the first interface circuit through the conductive materials, and wherein the memory controller is configured to control the plurality of core dies, wherein the memory controller is further configured to independently adjust refresh cycles of the plurality of bank arrays included in the plurality of core dies based on temperature values obtained from the plurality of first temperature sensors and the second temperature sensor. The memory control may be further configured to independently adjust refresh cycles of the plurality of bank arrays included in the plurality of core dies based only on temperature values obtained from the plurality of first temperature sensors and the second temperature sensor.

At least some of the above and other features of the disclosure are set out in the claims.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a diagram showing a memory system according to an embodiment;
FIG. 2 is a block diagram showing a stacked memory device according to embodiments;
FIG. 3 is a block diagram showing a memory device corresponding to one channel included in a core die according to an embodiment;
FIG. 4 is a diagram illustrating a memory system according to an embodiment;
FIG. 5 is a diagram explaining a bank, temperature information, estimated temperature information and refresh rate information, according to an embodiment;
FIG. 6 is a diagram illustrating a memory device according to an embodiment;
FIG. 7 is a diagram illustrating a bank, temperature information, estimated temperature information and refresh rate information, according to an embodiment;
FIG. 8 is a flowchart illustrating an operation method of a memory system according to an embodiment;
FIG. 9 is a flowchart illustrating a temperature estimation method according to an embodiment;
FIG. 10 is a flowchart illustrating a temperature estimation method according to an embodiment;
FIG. 11 is a diagram illustrating a refresh cycle according to an embodiment;
FIG. 12 shows the configuration of a semiconductor device according to an embodiment;
FIG. 13 is a block diagram illustrating a CXL base die according to an embodiment;
FIG. 14 is a diagram illustrating a stacked memory device according to an embodiment; and
FIG. 15 is a block diagram showing a computing system according to an embodiment.

### DETAILED DESCRIPTION

Hereinafter, embodiments of the disclosure are described in detail with reference to the attached drawings.

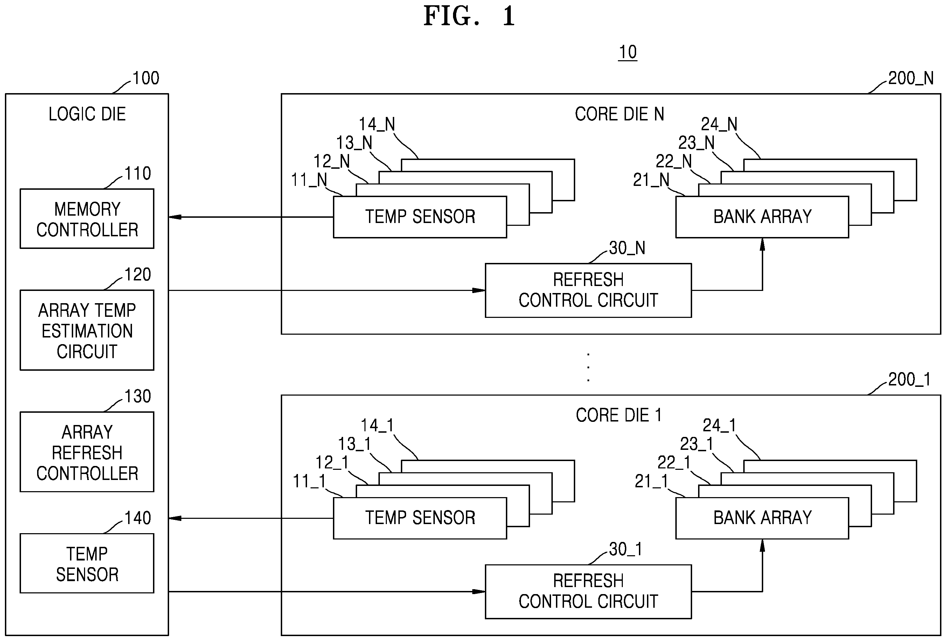

FIG. 1 is a diagram showing a memory system 10 according to an embodiment.

The memory system 10 according to an embodiment may include a logic die 100 and a plurality of core dies, for example a first core die 200_1 to an Nth core 200_N. A wide range of input and output using a multi-channel interface may be provided between the logic die 100 and the first to Nth core dies 200_1 to 200_N. For example, memory system 10 may be high-bandwidth memory (HBM).

The logic die 100 and the first to Nth core dies 200_1 to 200_N may be stacked in a vertical direction. The logic die 100 may be placed at a lowest portion of the memory system 10, and the first to Nth core dies 200_1 to 200_N may be stacked on the logic die 100.

The logic die 100 may control the overall operation of the first to Nth core dies 200_1 to 200_N. For example, the logic die 100 may be referred to as a host and may be implemented as a system on chip (SoC). However, this is an example, and the logic die 100 may be implemented in various forms other than a (SoC).

The logic die 100 may include a memory controller 110, an array temperature estimation circuit 120, and an array refresh controller 130. In the drawings, the word "temperature" may be abbreviated "TEMP"). While the memory controller 110, array temperature estimation circuit 120 and array refresh controller 130 have been described and illustrated as separate disparate elements, they may be incorporated into a single element, e.g., the memory controller 110 which performs the functions of the memory controller 110, temperature estimation circuit 120 and array refresh controller 130. In this arrangement, the logic die 100 may include a memory controller 110 and a temperature sensor 140.

The memory controller 110 may control the overall operation of the first to Nth core dies 200_1 to 200_N. For example, the memory controller 110 may provide write data and a write command to control the first to Nth core dies 200_1 to 200_N to store the write data. For example, the memory controller 110 may provide a read command to control the first to Nth core dies 200_1 to 200_N to read data.

The array temperature estimation circuit 120 may estimate the temperature value corresponding to (i.e., of) an unit array area included in the first to Nth core dies 200_1 to 200_N. The unit array area may be an area including one bank array, or a bank array group including a plurality of bank arrays. According to embodiments, the unit array area may include one bank array, but embodiments are not limited thereto. According to embodiments, each of the first to Nth core dies 200_1 to 200_N may include a plurality of bank arrays, a corresponding plurality of temperature sensors, and a refresh circuit. For example, the first core die 200_1 may include temperature sensor 11_1 through temperature sensor 14_1, bank array 21_1 through bank array 24_1, and a refresh control circuit 30_1. Similarly, the Nth core die may include temperature sensor 11_N through temperature sensor 14_N and bank array 21_N through bank array 24_N, and a refresh control circuit 30_N. According to embodiments, the array temperature estimation circuit 120 may obtain temperature values from the temperature sensors 11_1 to 14_1 and 11_N to 14_N and may estimate temperature values of the bank arrays 21_1 to 24_1 and 21_N to 24_N based on the obtained temperature values. The array temperature estimation circuit 120 may estimate temperature values corresponding to the bank arrays 21_1 to 24_1 and 21_N to 24_ N using the temperature value corresponding to a temperature sensor 140 included in the logic die 100.

The array temperature estimation circuit 120 may use the temperature value corresponding to a temperature sensor assigned to at least one of the bank arrays 12_1 to 24_1 and 21_N to 24_N to estimate the temperature value corresponding to a bank array to which no temperature sensor is assigned among the bank arrays 12_1 to 24_1 and 21_N to 24_N. For example, the array temperature estimation circuit 120 may estimate the temperature value corresponding to the bank array to which no temperature sensor is assigned by performing interpolation based on the temperature values of temperature sensors disposed around the bank array to which no temperature sensor is assigned. In some embodiments, the array temperature estimation circuit 120 may estimate the temperature value corresponding to the bank array to which no temperature sensor is assigned by using the temperature value corresponding to the temperature sensor closest to the bank array to which no temperature sensor is assigned. For example, the array temperature estimation circuit 120 may estimate the temperature value corresponding to the bank array to which no temperature sensor is assigned based on the temperature sensor included in the core die adjacent to the core die including the bank array to which no temperature sensor is assigned. For example, the array temperature estimation circuit 120 may estimate the temperature value corresponding to the bank array to which no temperature sensor is assigned based on the temperature sensor assigned to the bank array sharing the same channel as the bank array to which no temperature sensor is assigned. For example, the array temperature estimation circuit 120 may estimate the temperature value corresponding to the bank array to which no temperature sensor is assigned based on the temperature value corresponding to the temperature sensor 140 included in the logic die 100. Estimating the temperature value corresponding to a bank array to which no temperature sensor is assigned may improve performance as the refresh cycle of the bank array may be based on an estimated temperature value.

The array refresh controller 130 may obtain temperature estimate values for the bank arrays 21_1 to 24_1 and 21_N to 24_N from the array temperature estimation circuit 120. The array refresh controller 130 may adjust the refresh rate of the bank arrays 21_1 to 24_1 and 21_N to 24_N based on the temperature estimate value. For example, the array refresh controller 130 may include information about the refresh rate in commands provided to the first to Nth core dies 200_1 to 200_N.

The first to Nth core dies 200_1 to 200_N may store data. For example, each of the first to Nth core dies 200_1 to 200_N may be referred to as a memory die, and may be an HBM that provides wide input/output in a multi-channel interface type. However, this is an example, and the memory device 200 may be implemented in various forms other than HBM.

Each of the bank arrays 21_1 to 24_1 and 21_N to 24_N may include a plurality of memory cells. For example, the plurality of memory cells may be DRAM cells. However, embodiments are not limited thereto, and the memory cells may be resistive random access memory (RRAM) cells, ferroelectric random access memory (FRAM) cells, phase change random access memory (PRAM) cells, thyristor random access memory (TRAM) cells, magnetic random access memory (MRAM) cells, or flash, cells. Hereinafter, embodiments are described focusing on an embodiment in which the memory cells are DRAM cells.

The temperature sensors 11_1 to 14_1 and 11_N to 14_N may be assigned to the bank arrays 21_1 to 24_1 and 21_N to 24_N, respectively. Accordingly, the temperature sensors 11_1 to 14_1 and 11_N to 14_N may obtain the temperature values corresponding to the bank arrays 21_1 to 24_1 and 21_N to 24_N. However, in some embodiments, temperature sensors may not be assigned to some of the bank arrays 21_1 to 24_1 and 21_N to 24_N. The array temperature estimation circuit 120 may use the temperature values corresponding to the temperature sensors 11_1 to 14_1 and 11_N to 14_N as temperature values corresponding to bank arrays to which the temperature sensors are assigned. In addition, the array temperature estimation circuit 120 may estimate the temperature value corresponding to the bank array to which no temperature sensor is assigned by using the temperature value corresponding to the temperature sensor assigned to the bank arrays disposed adjacent to the bank arrays to which no temperature sensor is assigned.

The refresh control circuits 30_1 and 30_N may control the refresh rate of the refresh operation performed on the bank arrays 21_1 to 24_1 and 21_N to 24_N. The refresh control circuits 30_1 and 30_N may control the refresh rate based on information from the array refresh controller 130.

According to an embodiment, the refresh rates of bank arrays included in the same core die may be controlled differently from each other. For example, the refresh rates of one or more bank arrays included in the same core die may be controlled independently. Accordingly, because an optimized refresh operation may be performed, improved bandwidth may be provided, compared to controlling the refresh rates of all bank arrays to be same based on the hottest portion of one core die, which may be referred to as a hot spot of the core die. Conventional devices may control a refresh rate of a core die based on a hot spot of the core die, i.e., a highest temperature of the die. Thus, the refresh rates of all of the bank arrays of that core die may have the same refresh rate. In contrast, in one embodiment, the refresh rates of bank arrays included in the same core die may be controlled differently, i.e., independently.

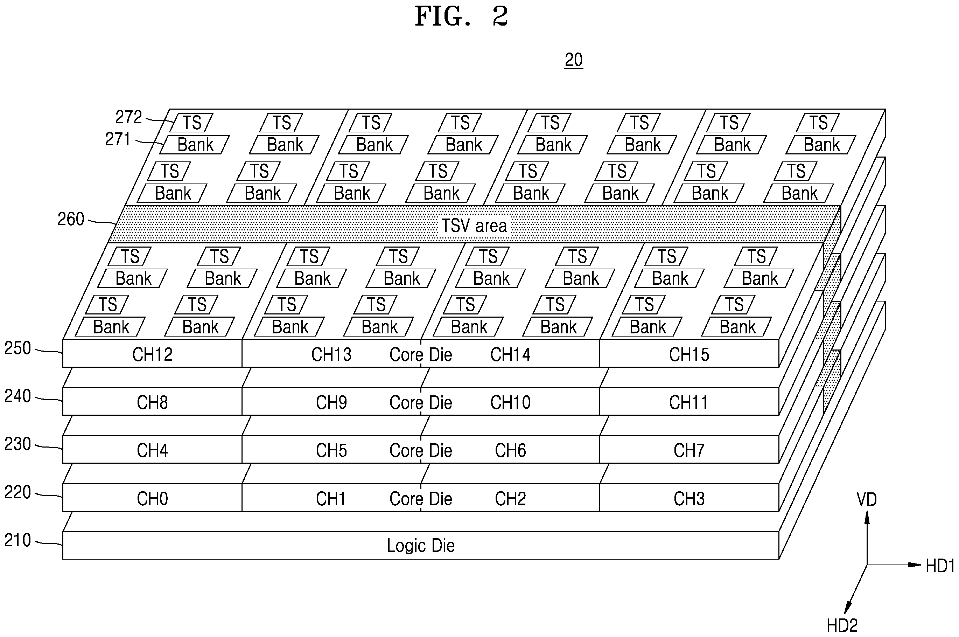

FIG. 2 is a block diagram showing a stacked memory device according to embodiments. Referring to FIG. 2, the stacked memory device 20 may include a logic die 210 and a plurality of core dies, for example core die 220, core die 230, core die 240, and core die 250. For example, the logic die 210 may also be referred to as a host die, base die, master die, etc., and each of the core dies 220 to 250 may also be referred to as a memory die, a slave die, etc. In FIG. 2, the stacked memory device 20 is illustrated as including four core dies, (e.g., core dies 220 to 250), but embodiments are not limited thereto, and the number of core dies may vary. For example, the stacked memory device 20 may include eight, twelve, or sixteen core dies.

The logic die 210 and the core dies 220 to 250 may be stacked and electrically connected through through silicon vias (TSV). Accordingly, the stacked memory device 20 may have a three-dimensional memory structure in which a plurality of dies 210 to 250 are stacked. For example, the stacked memory device 20 may be implemented based on HBM or hybrid memory cube (HMC) standards. The logic die 210 and core dies 220 to 250 may be stacked in a vertical direction VD (e.g., Z-axis). The logic dies 210 and core dies 220 to 250 may each extend in first and second horizontal directions HD1, HD2 (e.g., X and Y-axis). The vertical direction VD may be perpendicular to the horizontal directions HD1, HD2. The logic die 210 may be below, in the vertical direction VD, the core dies 220 to 250. The core dies 220 to 250 may partially or completely overlay the logic die 210 in the vertical direction VD. The core dies 220 to 250 and the TSV may partially or completely overlay the logic die 210 in the vertical direction VD. The core dies 220 to 250 may be stacked in the vertical direction VD. The core dies 220 to 250 may be stacked one on top of the other in the vertical direction VD. Each core die may partially or completely overlay a vertically adjacent (below) core die, except for a first core die 220 which overlays the logic die 210.

The stacked memory device 20 may support a plurality of functionally independent channels (or vaults). For example, as shown in FIG. 2, the stacked memory device 20 may support sixteen channels CH0 to CH15. When each of the channels CH0 to CH15 supports sixty-four data transmission paths (e.g., when there are sixty-four data signal DQ pins corresponding to each of the channels CH0 to CH15), the stacked memory device 20 including sixteen channels CH0 to CH15 may support 1024 data transmission paths. However, embodiments are not limited to thereto, the stacked memory device 20 may support more than 1024 data transmission paths and may support various numbers of channels (e.g., eight channels). For example, when the stacked memory device 20 supports eight channels and each of the channels supports 128 data transmission paths, the stacked memory device 20 may support 1024 data transfer paths.

Each of the core dies 220 to 250 may support at least one channel. For example, as shown in FIG. 2, each of the core dies 220 to 250 may support four channels. In some embodiments, the core die 220 may support channel CH0, channel CH1, channel CH2, and channel CH3; the core die 230 may support channel CH4, channel CH5, channel CH6, and channel CH7; the core die 240 may support channel CH8, channel CH9, channel CH10, and channel CH11; and core die 250 may support channel CH12, channel CH13, channel CH14, channel CH15. In this case, the core dies 220 to 250 may support different channels. However, embodiments are not limited to thereto, and at least two of the core dies may support the same channel. For example, the stacked memory device 20 may include a plurality of stacks, and each of the stacks may include four cores dies. According to embodiments, one of the four core dies included in one stack and one of the four core dies included in another stack may support the same channel. In this case, core dies supporting the same channel may be distinguished or identified by a stack ID (SID).

Each of the channels may correspond to an independent command and data interface. For example, each channel may be independently clocked based on independent timing requirements and may not be synchronized with each other.

In FIG. 2, an area of a core die in which a plurality of circuits corresponding to a channel are disposed may be referred to as a channel area. A channel area may include a plurality of bank arrays 271. Each of the bank arrays 271 may include memory cells connected to word lines and bit lines, a sense amplifier, etc. For example, each of channel areas corresponding to channels CH0 to CH15 may include thirty-two bank arrays 271. However, embodiments are not limited to thereto, and each of channel areas corresponding to the channels CH0 to CH15 may include eight or more bank arrays 271. In FIG. 2, the bank arrays 271 included in one channel are shown as being included in one channel area of one core die, but embodiments are not limited thereto. For example, the bank arrays 271 included in one channel may be distributed over a plurality of channel areas of plurality of core dies. For example, when two of the core dies support the first channel CH0, the bank arrays 271 of the first channel CH0 may be distributed over a plurality of channel areas of the two core dies.

In an embodiment, one channel can be divided into two independently operating pseudo channels. For example, the pseudo channels may share the command and clock inputs of the channel (e.g., the clock signal CK and/or the clock enable signal CKE), but may decode and execute commands independently. For example, when one channel supports sixty-four data transmission paths, each of the pseudo channels may support thirty-two data transmission paths. For example, when one channel includes thirty-two bank arrays 271, each of the pseudo channels may include sixteen bank arrays 271.

The logic die 210 and the core dies 220 to 250 may include a TSV area 260. According to embodiments, TSVs configured to penetrate the dies logic die 210 and the core dies 220 to 250 may be disposed in the TSV area 260. The logic die 210 may transmit and receive various signals with the core dies 220 to 250 through TSVs. Each of the core dies 220 to 250 may transmit and receive signals with the logic die 210 and other core dies through TSVs. In this case, signals may be transmitted and received independently through corresponding TSVs for each channel. For example, when the logic die 210 transmits a data signal to the first channel CH0 to store data in the memory cell of the first channel CH0, the logic die 210 may transmit a data signal to the first core die 220 through TSVs corresponding to the first channel CH0. Accordingly, data may be stored in the memory cell of the first channel CH0.

In an embodiment, a power supply voltage VDDQL may be used for signal transmission through TSVs. The power supply voltage VDDQL may be less than a power supply voltage VDDQ used for the overall operation of the logic die 210. For example, the power supply voltage VDDQ may be 1.1V, and the power supply voltage VDDQL may be 0.4V, but embodiments are not limited thereto.

In an embodiment, the logic die 210 may include a channel controller corresponding to each channel. The channel controller may manage memory reference operations of the corresponding channel and determine timing requirements of the corresponding channel.

In an embodiment, the stacked memory device 20 may further include an error correction code (ECC) circuit to detect and correct data errors. For example, in a write operation, the ECC circuit may generate parity bits for data. In a read operation, the ECC circuit may detect and correct an error in data transmitted from one of the core dies 220 to 250 using parity bits.

Each of the logic die 210 and core dies 220 to 250 may include at least one temperature sensor 272. Temperature values sensed by the plurality of temperature sensors 272, e.g., temperature values sensed by the temperature sensors 272 of the core die 220 to 250, may be provided to the logic die 210. The logic die 210 may estimate the temperature value for each of the plurality of bank arrays 271 based on the temperature values. The logic die 210 may set or determine the refresh rate of each of the plurality of bank arrays 271 based on the estimated temperature values. The logic die 210 may provide information about the set refresh rate to the core dies 220 to 250. The refresh control circuit (e.g., the refresh control circuit 30_1 of FIG. 1) included in the core dies 220 to 250 may independently control the refresh rate of each of the plurality of bank arrays. Accordingly, because an optimized refresh operation may be performed, improved bandwidth may be provided, compared to controlling the refresh rates of all bank arrays based on the hottest portion of one core die, that is, the hot spot.

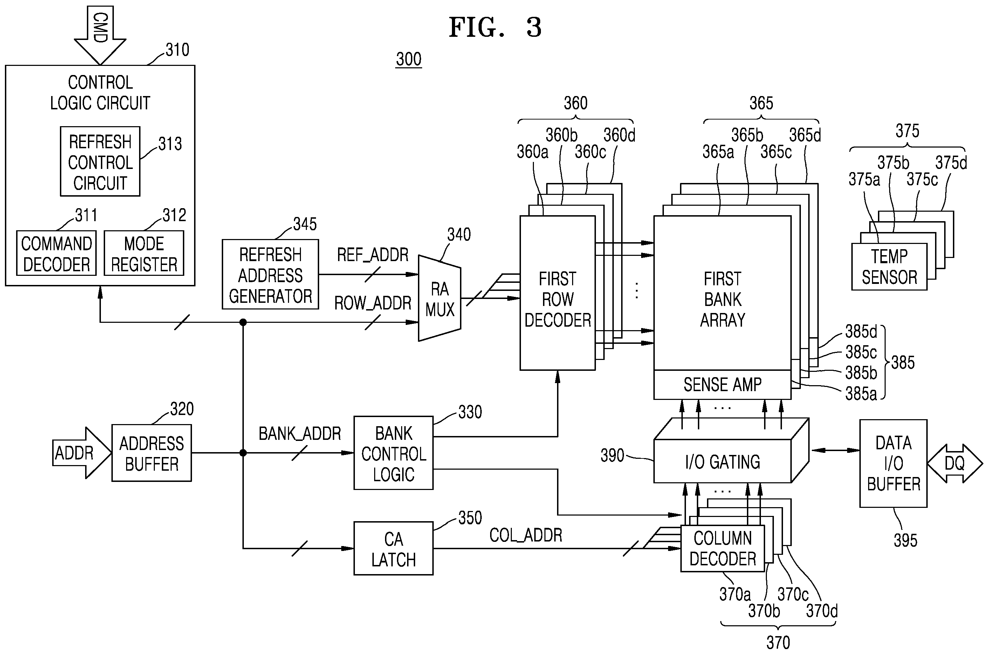

FIG. 3 is a block diagram showing a memory device corresponding to one channel included in a core die.

Referring to FIG. 3, the memory device 300 may include a control logic circuit 310, an address buffer 320, a bank control logic 330, a row address multiplexer 340 (illustrated as "RA MUX"), a refresh address generator 345, a column address latch 350 (illustrated as "CA LATCH"), and a row decoder 360, a memory cell array 365, a column decoder 370, a temperature sensor 375, a sense amplifier unit 385, an input/output gating circuit 390 (illustrated as "I/O GATING"), and a data input/output buffer 395 (illustrated as "DATA I/O BUFFER"). The area where the memory device 300 of FIG. 3 is formed on the core die may be referred to as a channel area.

The memory cell array 365 may include a first bank array 365a, a second bank array 365b, a third bank array 365c, and a fourth bank array 365d. Additionally, the row decoder 360 may include a first bank row decoder 360a connected to the first bank array 365a, a second bank row decoder 360b connected to the second bank array 365b, a third bank row decoder 360c connected to the third bank array 365c, and a fourth bank row decoder 360d connected to the fourth bank array 365d. Similarly, the column decoder 370 may include a first bank column decoder 370a connected to the first bank array 365a, a second bank column decoder 370b connected to the second bank array 365b, a third bank column decoder 30c connected to the third bank array 365c, and a fourth bank column decoder 370d connected to the fourth bank array 365dFurther, and the sense amplifier unit 385 may include a first bank sense amplifier 385a connected to the first bank array 365a, a second bank sense amplifier 385b connected to the second bank array 365b, a third bank sense amplifier 385c connected to the third bank array 365c, and a fourth bank sense amplifier 385d connected to the fourth bank array 365d.

The first to fourth bank arrays 365a to 365d, the first to fourth bank sense amplifiers 385a to 385d, the first to fourth bank column decoders 370a to 370d, and the first to fourth bank row decoders 360a to 360d may be referred to as first to fourth banks. For example, the first bank array 365a, the first bank sense amplifier 385a, the first bank column decoder 370a, and the first bank column decoder may be referred to as a first bank, and the other elements may be referred to similarly. Each of the first to fourth bank arrays 365a to 365d may include a plurality of word lines, a plurality of bit lines, and a plurality of memory cells formed at intersections of the word lines and the bit lines.

FIG. 3 shows an example of a memory device including four banks, but embodiments are not limited thereto, and in some embodiments, the memory device 300 may include any number of banks.

The address buffer 320 may receive an address ADDR including a bank address BANK ADDR, a row address ROWADDR, and a column address COL_ADDR, from the memory controller (e.g., the memory controller 110 of FIG. 1). The address buffer 320 may provide the received bank address BANK_ADDR to the bank control logic 330, the received row address ROW_ADDR to the row address multiplexer 340, and the received column address COL_ADDR to the column address latch 350.

The bank control logic 330 may generate bank control signals in response to or based on the bank address BANK_ADDR. In response to or based on the bank control signals, a bank row decoder corresponding to the bank address BANK_ADDR from among the first to fourth bank row decoders 360a to 360d may be activated, and a bank column decoder corresponding to the bank address BANK_ADDR among the first to fourth bank column decoders 370a to 370d may be activated.

The row address multiplexer 340 may receive the row address ROW_ADDR from the address buffer 320 and a refresh row address REF_ADDR from the refresh address generator 345. The row address multiplexer 340 may selectively output the row address ROW_ADDR or the refresh row address REF_ADDR as a row address RA. The row address RA output from the row address multiplexer 340 may be applied to the first to fourth bank row decoders 360a to 360d, respectively.

The bank row decoder activated by the bank control logic 330 may decode the row address RA output from the row address multiplexer 340 and activate the word line corresponding to the row address RA. For example, the activated bank row decoder may apply a word line driving voltage to the word line corresponding to the row address RA. The activated bank row decoder may generate a word line driving voltage using the power supply voltage VDD and provide the word line driving voltage to the corresponding word line.

The column address latch 350 may receive the column address COL_ADDR from the address buffer 320 and temporarily store the received column address COL_ADDR or the mapped column address MCA. Additionally, the column address latch 350 may gradually increase the received column address COL_ADDR in burst mode. The column address latch 350 may apply the temporarily stored or gradually increased column address COL_ADDR to the first to fourth bank column decoders 370a to 370d, respectively.

Among the first to fourth bank column decoders 370a to 370d, the bank column decoder activated by the bank control logic 330 may activate the sense amplifier corresponding to the bank address BANK_ADDR and the column address COL_ADDR through an input/output gating circuit 390.

The input/output gating circuit 390 may include circuits for gating input data and/or output data (which may be referred to as input/output data), input data mask logic, read data latches for storing data output from the first to fourth bank arrays 365a to 365d, and write drivers for writing data to first to fourth bank arrays 365a to 365d.

Data read from one of the first to fourth bank arrays 365a to 365d may be sensed by a sense amplifier corresponding to the one bank array and stored in the read data latches.

The data stored in the read data latches may be provided to the memory controller (e.g., the memory controller 110 in FIG. 1) through the data input/output buffer 395. Data to be written in one of the first to fourth bank arrays 365a to 365d may be provided to the data input/output buffer 395 from the memory controller (e.g., the memory controller 110 in FIG. 1). Data provided to the data input/output buffer 395 is provided to the input/output gating circuit 390.

The control logic circuit 310 may control the operation of the memory device 300. For example, the control logic circuit 310 may generate control signals for causing or controlling the memory device 300 to perform a write operation or a read operation. The control logic circuit 310 may include a command decoder 311 for decoding the command CMD received from the memory controller (e.g., the memory controller 110 in FIG. 1) and a mode register 312 for setting the operation mode of the memory device 300.

According to an embodiment, the control logic circuit 310 may include a refresh control circuit 313. The refresh control circuit 313 may receive information about the refresh rate from the array refresh controller (e.g., the array refresh controller 130 in FIG. 1) and may independently control the refresh rate for the first to fourth bank arrays 365a to 365d. For example, the refresh rates of bank arrays included in the same core die may be controlled independently. Accordingly, because an optimized refresh operation may be performed, improved bandwidth may be provided, compared to controlling the refresh rates of all bank arrays based on the hottest part of one core die, that is, the hotspot.

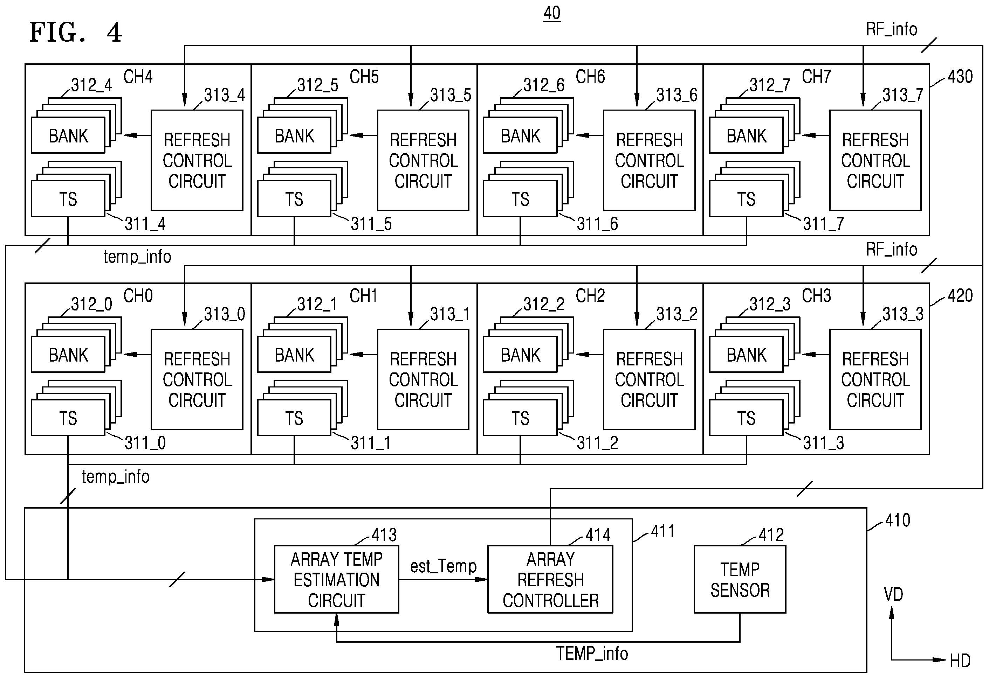

FIG. 4 is a diagram illustrating a memory system 40 according to an embodiment.

Referring to FIG. 4, the memory system 40 may include a logic die 410, a core die 420, and a core die 430 stacked in a vertical direction VD. Although FIG. 4 shows an example in which the memory system 40 includes two core dies, embodiments are not limited thereto, and the memory system 40 may include any number of core dies. The logic die 410 and the core dies 420 and 430 may be connected to each other through bumps, balls, TSVs, etc. As shown in FIG. 4, the logic die 410 and core dies 420, 430 each extend in a horizontal direction HD. The vertical direction VD is generally perpendicular to the horizontal direction HD. The core die 430 partially overlays the core die 420 in the vertical direction VD, and the core die 420 completely overlays the logic die 410 in the vertical direction VD, although embodiments are not limited thereto, and various other stacked structures may be present.

The logic die 410 may include a memory controller 411 and a temperature sensor 412. The memory controller 411 may include an array temperature estimation circuit 413 and an array refresh controller 414. Although FIG. 4 shows an example in which the memory controller 411 includes an array temperature estimation circuit 413 and an array refresh controller 414, embodiments are not limited thereto. The memory controller 411, the array temperature estimation circuit 413, and the array refresh controller 414 may be implemented as separate circuits.

Each of the core dies 420 and 430 may support multiple channels. For example the core die 420 may channel CH0, channel CH1, channel CH2, and channel CH3, and the core die 430 may support channel CH4, channel CH5, channel CH6, and channel CH7. For example, the core die 420 may include channel areas corresponding to channels CH0 to CH3, the core die 430 may include channel areas corresponding to channels CH4 to CH7. Each channel area may include a plurality of banks, temperature sensors, and a refresh control circuit. For example, the refresh control circuit 313_0 may control the refresh rate of the plurality of banks 312_0 using a command transmitted through the channel CH0.

Although FIG. 4 illustrates an example in which the memory system 40 includes four banks and four temperature sensors in each of the plurality of channel areas corresponding to channels CH0 to CH7, embodiments are not limited thereto, and the memory system 40 may include any number of banks and any number of temperature sensors in each of the plurality of channel areas.

According to embodiments, the memory system 40 may include multiple pluralities of temperature sensors. For example temperature sensors 311_0 may correspond to channel CH0, temperature sensors 311_1 may correspond to channel CH1, temperature sensors 311_2 may correspond to channel CH2, temperature sensors 311_3 may correspond to channel CH3, temperature sensors 311_4 may correspond to channel CH4, temperature sensors 311_4 may correspond to channel CH5, temperature sensors 311_6 may correspond to channel CH6, and temperature sensors 311_7 may correspond to channel CH7. The array temperature estimation circuit 413 may obtain temperature information temp_info from the temperature sensors 311_0 to 311_7 included in each of the plurality of channel areas corresponding to channels CH0 to CH7.

According to embodiments, the memory system 40 may include a plurality of temperature sensors which may be respectively assigned to a plurality of banks. For example temperature sensor 311_0 may be assigned to bank 312_0, temperature sensor 311_1 may be assigned to bank 312_1, temperature sensor 311_2 may be assigned to bank 312_2, temperature sensor 311_3 may be assigned to bank 312_3, temperature sensor 311_4 may be assigned to bank 312_4, temperature sensor 311_5 may be assigned to bank 312_5, temperature sensor 311_6 may be assigned to bank 312_6, and temperature sensor 311_7 may be assigned to bank 312_7. The temperature sensor assigned to a bank may indicate (or obtain) the temperature (e.g., a temperature value) near the bank. For example, the temperature sensors 311_0 may indicate the temperature near the banks 312_0.

The array temperature estimation circuit 413 may generate estimated temperature information est_Temp based on the temperature information temp_info. The estimated temperature information est_Temp may include temperature values estimated for the banks 312_0 to 312_7. When the temperature sensors 311_0 to 312_7 are placed very close to the banks 312_0 to 312_7, the reliability of the temperature information temp_info may be relatively high, but when the temperature sensors 311_0 to 312_7 are placed far from the banks 312_0 to 312_7, the reliability of the temperature information temp_info may be relatively low. Additionally, when the number of temperature sensors 311_0 to 312_7 is less than the number of banks 312_0 to 312_7, the reliability of the temperature information temp_info may be relatively low. The array temperature estimation circuit 413 may estimate the temperature of the location where the actual bank is placed by using an interpolation method based on the temperature values corresponding to the temperature sensors 311_0 to 311_7 included in the temperature information temp_info. A temperature estimated based on the interpolation method may be based on a distance of a bank from a respective temperature sensor.

Because the circuits included in the logic die 410 may perform various operations, the temperature of the logic die 410 may be higher than the temperature of the core dies 420 and 430. Accordingly, the temperature of the core die 420 adjacent to the logic die 410 may be higher than the temperature of the core die 430. According to an embodiment, by using the temperature value corresponding to the temperature sensor 412 included in the logic die 410 to generate estimated temperature values for the banks included in the lowest core die 420, the temperature of the core die 420 may be more accurately estimated.

According to an embodiment, by estimating the temperature of the banks 312_0 to 312_7 based on the temperature information temp_info about the temperature value sensed by the temperature sensors 311_0 to 311_7, a refresh rate optimized for the bank temperature may be provided.

The array refresh controller 414 may generate refresh rate information RF_info based on the estimated temperature information est_temp. The refresh rate information RF_info may include refresh rate values corresponding to estimated temperature values.

The refresh control circuits 313 _0 to 313_7 may independently control the refresh rate of each of the plurality of banks 312_0 to 312_7 based on the refresh rate information RF_info. Accordingly, because an optimized refresh operation may be performed, improved bandwidth may be provided, compared to controlling the refresh rates of all bank arrays based on the hottest part of one core die (e.g., the hotspot).

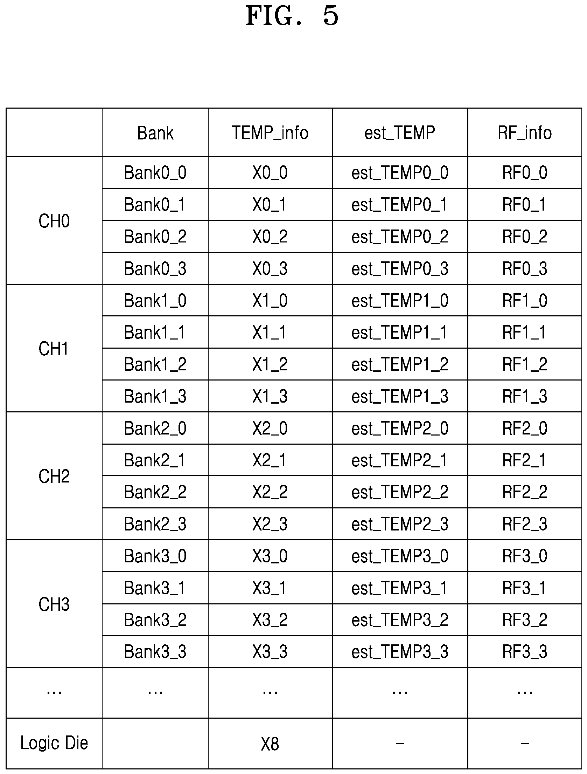

FIG. 5 is a diagram explaining a bank, temperature information, estimated temperature information and refresh rate information, according to an embodiment. FIG. 5 may be explained with reference to FIG. 4.

Referring to FIG. 5, a channel area corresponding to the channel CH0 may include a plurality of banks, for example a bank Bank0_0, a Bank0_1, a Bank0_2, and a Bank0_3. The temperature sensors 311_0 may be assigned to the banks Bank0_0 to Bank0_3, and the sensed temperature value may be X0_0, X0_1, X0_2, and X0_3. The temperature sensors 311_0 may provide the temperature information TEMP_info to the array temperature estimation circuit 413. A channel area corresponding to the channel CH1 may include a plurality of banks, for example a bank Bank1_0, a Bank1_1, a Bank1_2, and a Bank1_3. The temperature sensors 311_1 may be respectively assigned to the banks Bank1_0 to Bank1_3, and the sensed temperature values may be X1_0, X1_1, X1_2, and X1_3. The temperature sensors 311_1 may provide the temperature information TEMP_info to the array temperature estimation circuit 413. A channel area corresponding to the channel CH2 may include a plurality of banks, for example a bank Bank2_0, a Bank2_1, a Bank2_2, and a Bank2_3. The temperature sensors 311_2 may be respectively assigned to the banks Bank2_0 to Bank2_3, and the sensed temperature values may be X2_0, X2_1, X2_2, and X2_3. The temperature sensors 311_2 may provide the temperature information TEMP_info to the array temperature estimation circuit 413. A channel area corresponding to the channel CH3 may include a plurality of banks, for example a bank Bank3_0, a Bank3_1, a Bank3_2, and a Bank3_3. The temperature sensors 311_3 may be respectively assigned to the banks Bank3_0 to Bank3_3, and the sensed temperature values may be X3_0, X3_1, X3_2, and X3_3. The temperature sensors 311_3 may provide the temperature information TEMP_info to the array temperature estimation circuit 413.

Although not shown in FIG. 5, the temperature sensors 311_4 to 311_7 included in the channel areas corresponding to channels CH4 to CH7 may sense temperature and provide the temperature information TEMP_info including the sensed temperature values to the array temperature estimation circuit 413.

The array temperature estimation circuit 413 may generate the estimated temperature information est_TEMP based on the temperature information TEMP_info. The estimated temperature information est_TEMP may include an estimated temperature value corresponding to each of the banks. For example, the estimated temperature values corresponding to the banks Bank0_0 to Bank0_3 may be est_TEMP0_0, est_TEMP0_1, est_TEMP0_2, and est_TEMP0_3, the estimated temperature values corresponding to the banks Bank1_0 to Bank1_3 may be est_TEMP1_0, est TEMP1_1, est_TEMP1_2, and est_TEMP1_3, the estimated temperature values corresponding to the banks Bank2_0 to Bank2_3 may be est_TEMP2_0, est_TEMP2_1, est_TEMP2_2, and est_TEMP2_3, and the estimated temperature values corresponding to the banks Bank3_0 to Bank3_3 may be est_TEMP3_0, est_TEMP3_1, est_TEMP3_2, and est_TEMP3_3.

In some embodiments, the array temperature estimation circuit 413 may generate estimated temperature information est_TEMP including estimated temperature values corresponding to banks included in channel areas corresponding to channels CH4 to CH7.

In an embodiment, the array temperature estimation circuit 413 may generate the estimated temperature information est_TEMP based on X8, which may be the temperature value corresponding to the temperature sensor 412 included in the logic die 410. For example, by using the temperature value X8 of the temperature sensor 412 included in the logic die 410 to generate an estimated temperature value for the banks included in the lowest core die 420, the array temperature estimation circuit 413 may more accurately estimate the temperature of banks included in the core die 420.

The array refresh controller 414 may generate the refresh rate information RF_info based on the estimated temperature information est_TEMP. The refresh rate information RF_info may include refresh rate values corresponding to banks. For example, refresh rate value RF0_0 may correspond to Bank0_0, refresh rate value RF0 _1 may correspond to Bank0_1, refresh rate value RF0_2 may correspond to Bank0_2, and refresh rate value RF0_3 may correspond to Bank0_3. Similarly, refresh rate value RF1_0 may correspond to Bank1_0, refresh rate value RF1_1 may correspond to Bank1_1, refresh rate value RF1_2 may correspond to Bank1_2, and refresh rate value RF1_3 may correspond to Bank1_3; refresh rate value RF2_0 may correspond to Bank2_0, refresh rate value RF2_1 may correspond to Bank2_1, refresh rate value RF2_2 may correspond to Bank2_2, and refresh rate value RF2_3 may correspond to Bank2_3; and refresh rate value RF3_0 may correspond to Bank3_0, refresh rate value RF3_1 may correspond to Bank3_1, refresh rate value RF3_2 may correspond to Bank3_2, and refresh rate value RF3_3 may correspond to Bank3_3.

In some embodiments, the array refresh controller 414 may generate refresh rate values for banks included in channel areas corresponding to channels CH4 to CH7.

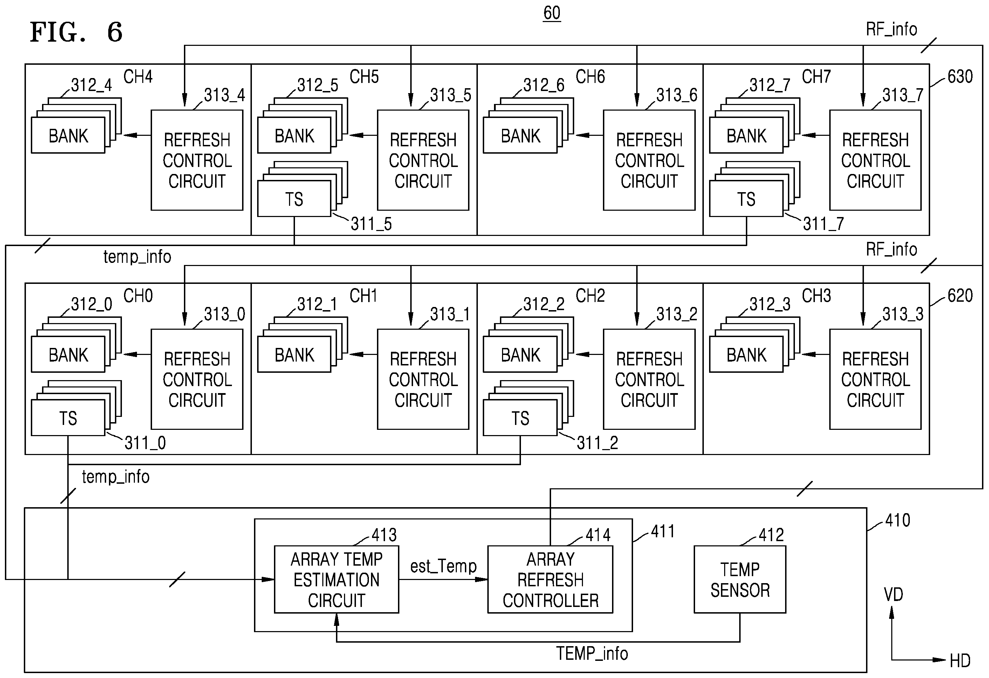

FIG. 6 is a diagram illustrating a memory device 60 according to an embodiment. As shown in FIG. 6, the logic die 410 and core dies 620, 630 each extend in a horizontal direction HD. The vertical direction VD is generally perpendicular to the horizontal direction HD. The core die 630 partially overlays the core die 620 in the vertical direction VD, and the core die 620 completely overlays the logic die 410 in the vertical direction VD, although embodiments are not limited thereto, and various other stacked structures may be present.

Unlike the example shown in FIG. 4, the memory system 60 may not include the temperature sensors 311_1, 311_3, 311_4, and 311_6. For example, the core dies 620 and 630 may not include temperature sensor, and the number of temperature sensors 311_0, 311_2, 311_5, and 311_7 may be less than the number of banks 312_0 to 312_7. Additionally, a temperature sensor may not be assigned to at least one of the banks 312_0 to 312_7.

In an embodiment, the area where the temperature sensors 311_0 and 311_2 are placed in the core die 620 and the area where the temperature sensors 311_5 and 311_7 are placed in the core die 630 may not overlap in the vertical direction VD.

Because the temperature sensors may not overlap in the vertical direction VD, the temperature sensors may be evenly distributed in the memory device 60. Accordingly, the temperature value corresponding to a bank to which no temperature sensor is assigned may be accurately estimated using temperature information temp_info including temperature values obtained from evenly distributed temperature sensors. For example, because the temperature sensor allocated to the banks 312_1 is not placed in the channel area corresponding to the channel CH1, the array temperature estimation circuit 413 may estimate the temperature values corresponding to the banks 312_1 of the channel CH1 using temperature values corresponding to temperature sensors in channel areas corresponding to channels CH0 and CH2 adjacent to channel area corresponding to chennal CH1 in the horizontal direction HD, temperature values corresponding to the temperature sensors 311_5 in the channel area corresponding to the channel CH5 adjacent to the channel area corresponding to the channel CH1 in the vertical direction VD and a temperature value corresponding to the temperature sensor 412 of the logic die 410 adjacent to the channel area corresponding to the channel CH1 in the vertical direction VD.

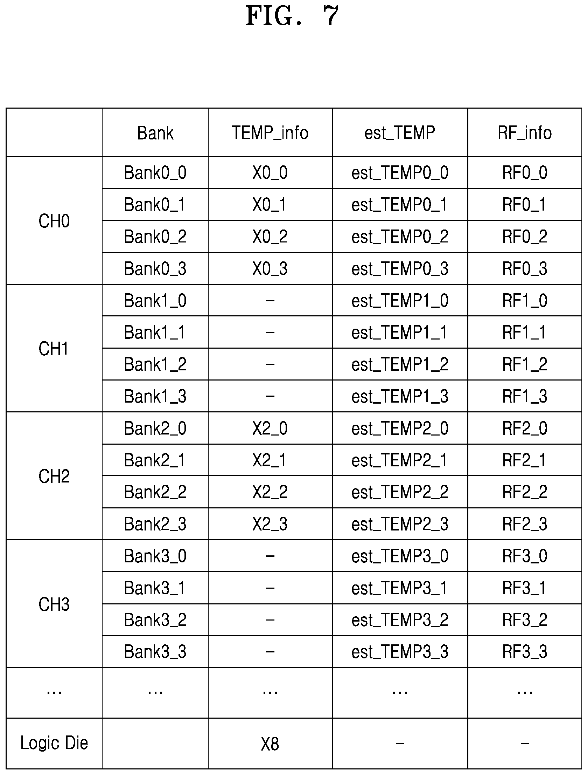

FIG. 7 is a diagram illustrating a bank, temperature information, estimated temperature information and refresh rate information, according to an embodiment. FIG. 7 may be explained with reference to FIG. 6.

Unlike the core die 420 of FIG. 4, the temperature sensor 311_1 corresponding to the channel CH0 and the temperature sensor 311_3 corresponding to the channel CH3 may not be disposed in the core die 620 of FIG. 6. For example, temperature sensors may not be assigned to the banks Bank1_0 to Bank1_3 and Bank3_0 to Bank3_3.

Accordingly, referring to FIG. 7, the temperature information TEMP_info may not include temperature values corresponding to the banks Bank1_0 to Bank1_3 and Bank3_0 to Bank3_3.

However, the array temperature estimation circuit 413 may estimate the temperature of the banks Bank1_0 to Bank1_3 using temperature sensors located near the banks Bank1_0 to Bank1_3. For example, the array temperature estimation circuit 413 may generate estimated temperature values est_TEMP1_0 to est_TEMP1_3 corresponding to banks Bank1_0 to Bank1_3 disposed in the channel area corresponding to the channel CH1 using the temperature values X0_0 to X0_3 and X2_0 to X2_3 corresponding to temperature sensors 311_0 and 311_2 disposed in the channel areas corresponding to channels CH0 and CH2 adjacent to the channel area corresponding to the channel CH1 in the horizontal direction HD. In some embodiments, for example, the array temperature estimation circuit 413 may generate estimated temperature values est_TEMP1_0 to est_TEMP1_3 corresponding to banks Bank1_0 to Bank1_3 in the channel area corresponding to channel CH1 using temperature sensors 311_5 disposed in the channel area corresponding to channel CH5, which may be adjacent to the channel area corresponding to the channel CH1 in the horizontal direction HD. The channel area may refer to an area in which circuits that operate to independently write or read data transmitted/received through a channel are disposed. For example, the array temperature estimation circuit 413 may generate estimated temperature values est_TEMP1_0 to est_TEMP1_3 corresponding to banks Bank1_0 to Bank1_3 in the channel area corresponding to the channel CH1 using the temperature sensor 412 disposed on a logic die 410 adjacent to the channel area corresponding to the channel CH1 in the horizontal direction HD.

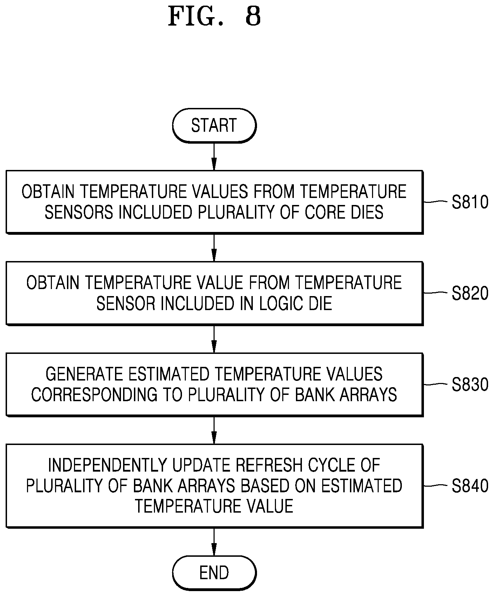

FIG. 8 is a flowchart illustrating an operation method of a memory system according to an embodiment. FIG. 8 may be explained with reference to FIG. 1.

Referring to FIG. 8, at operation S810, the array temperature estimation circuit 120 may obtain temperature values from the temperature sensors 11_1 to 14_1 and 11_N to 14_N included in the first to Nth core dies 200_1 to 200_N.

The temperature sensors 11_1 to 14_1 and 11_N to 14_N may be assigned to a plurality of bank arrays 21_1 to 24_1, 21_N, and 24_N. The number of temperature sensors 11_1 to 14_1 and 11_N to 14_N may be greater than, equal to, or less than the number of bank arrays 21_1 to 24_1, 21_N, and 24_N.

Furthermore, at operation S820, the array temperature estimation circuit 120 may obtain a temperature value from the temperature sensor 140 included in the logic die 100.

At operation S830, the array temperature estimation circuit 830 may generate an estimated temperature value corresponding to the plurality of bank arrays 21_1 to 24_1 and 21_Nto 24_N based on the temperature values obtained from the temperature sensors 11_1 to 14_1 and 11_N to 14_N and 140. In other words, the array temperature estimation circuit 830 may estimate a temperature value corresponding to the plurality of bank arrays 21_1 to 24_1 and 21_Nto 24_N based on the temperature values obtained from the temperature sensors 11_1 to 14_1 and 11_N to 14_N and 140.

For example, when the number of temperature sensors 11_1 to 14_1 and 11_N to 14_N is greater than or equal to the number of bank arrays 21_1 to 24_1, 21_N, and 24_N, the array temperature estimation circuit 830 may use the temperature values corresponding to (i.e., of) the temperature sensors assigned to the plurality of bank arrays 21_1 to 24_1, 21_N, and 24_N as estimated temperature values.

When the number of temperature sensors 11_1 to 14_1 and 11_N to 14_N is less than the number of bank arrays 21_1 to 24_1 and 21_N, 24_N, the array temperature estimation circuit 830 may estimate the temperature of the bank array to which no temperature sensor is assigned using methods such as interpolation or extrapolation. For example, the temperature value corresponding to the corresponding bank array may be estimated by averaging the temperature values corresponding to temperature sensors placed near the bank array to which no temperature sensor is assigned.

At operation S840, the array refresh controller 414 may independently update the refresh cycle of the plurality of bank arrays 21_1 to 24_1, 21_N, and 24_N based on the estimated temperature value. Accordingly, because an optimized refresh operation may be performed, improved bandwidth may be provided compared to controlling the refresh rates of all bank arrays based on the hottest portion of one core die (e.g., the hotspot).

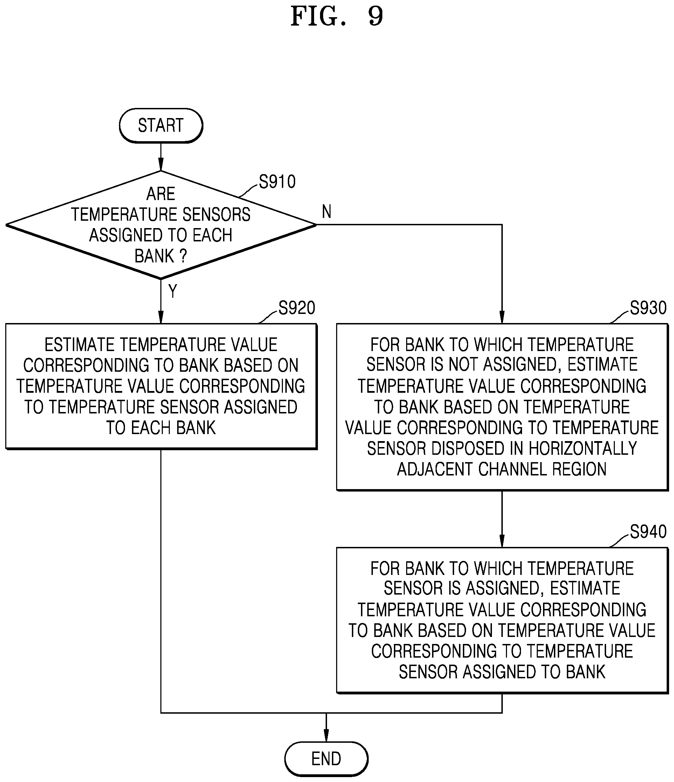

FIG. 9 is a flowchart illustrating a temperature estimation method according to an embodiment. FIG. 9 may correspond to operation S830 of FIG. 8.

Referring to FIG. 9, at operation S910, the method may include determining whether temperature sensors are assigned to each bank. When temperature sensors are assigned to each bank, or when the number of temperature sensors is equal to or greater than the number of banks ("Y" at operation S910), the array temperature estimation circuit 120 may estimate the temperature value corresponding to each bank based on the temperature value corresponding to the temperature sensor assigned to each bank at operation S920. The array temperature estimation circuit 120 may use the temperature value as is as the estimated temperature value, or may use a value obtained by adding or subtracting an offset to the temperature value as the estimated temperature value.

When temperature sensors are not assigned to each bank, or when the number of temperature sensors is less than the number of banks ("N" at operation S910), the array temperature estimation circuit 120, for a bank to which a temperature sensor is not assigned, may estimate the temperature value corresponding to a bank based on the temperature value corresponding to a temperature sensor disposed in a horizontally adjacent channel area at operation S930. For example, the temperature value corresponding to the corresponding bank may be estimated by averaging the temperature values corresponding to temperature sensors placed in adjacent channel areas.

For a bank to which the temperature sensor is assigned, the array temperature estimation circuit 120 may estimate the temperature value corresponding to the bank based on the temperature value corresponding to the temperature sensor assigned to the bank. At operation S940, the array temperature estimation circuit 120 may use the detected temperature value as the estimated temperature value, or may use a value obtained by adding or subtracting an offset to the detected temperature value as the estimated temperature value.

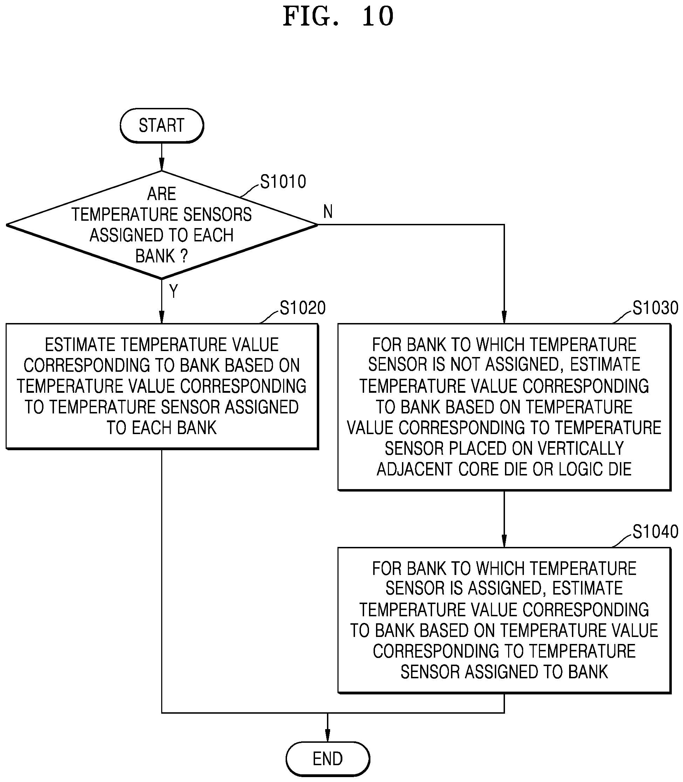

FIG. 10 is a flowchart illustrating a temperature estimation method according to an embodiment. FIG. 10 may correspond to operation S830 of FIG. 8.

Referring to FIG. 10, at operation S1010, the method may include determining whether temperature sensors are assigned to each bank. When temperature sensors are assigned to each bank, or when the number of temperature sensors is equal to or greater than the number of banks ("Y" at operation S1010), the array temperature estimation circuit 120 may estimate the temperature value corresponding to each bank based on the temperature value corresponding to the temperature sensor assigned to each bank in operation S1020. The array temperature estimation circuit 120 may use the detected temperature value as the estimated temperature value, or may use a value obtained by adding or subtracting an offset to the detected temperature value as the estimated temperature value.

When temperature sensors are not assigned to each bank, or when the number of temperature sensors is less than the number of banks ("N" at operation S1010), the array temperature estimation circuit 120, for a bank to which a temperature sensor is not assigned, may estimate the temperature value corresponding to a bank based on the temperature value corresponding to a temperature sensor placed on a vertically adjacent core die or logic die at operation S1030. For example, when a bank with no temperature sensor assigned is placed on the lowest core die, the temperature value corresponding to the corresponding bank may be estimated by averaging the temperature values corresponding to the temperature sensors placed on the adjacent core die and the temperature values corresponding to the temperature sensors placed on the logic die.

For a bank to which a temperature sensor is assigned, the array temperature estimation circuit 120 may estimate the temperature value corresponding to the bank based on the temperature value corresponding to the temperature sensor assigned to the bank. At operation S1040, the array temperature estimation circuit 120 may use the detected temperature value as the estimated temperature value, or may use a value obtained by adding or subtracting an offset to the detected temperature value as the estimated temperature value.

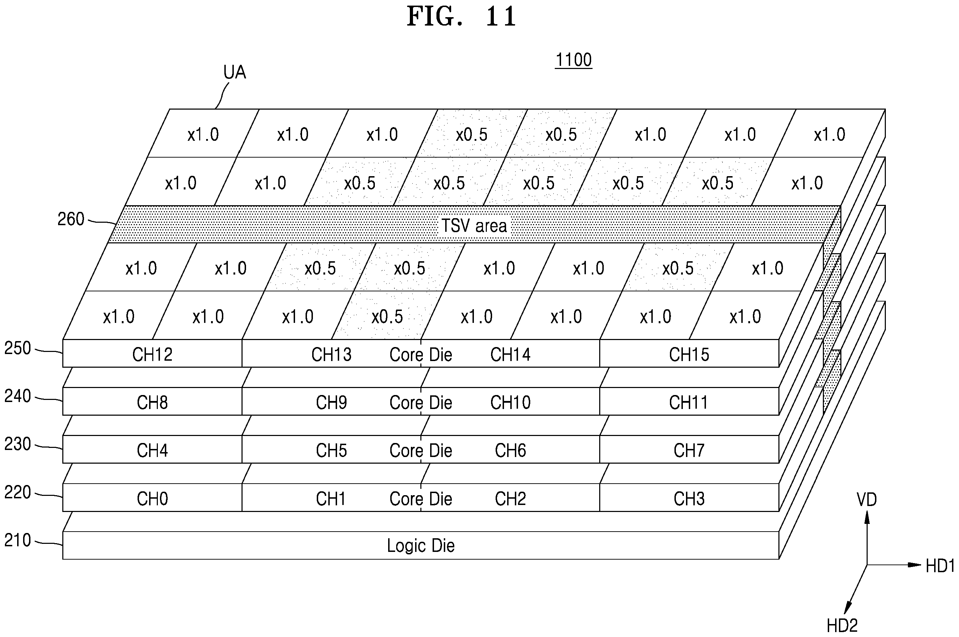

FIG. 11 is a diagram illustrating a refresh cycle according to an embodiment.

Referring to FIGS. 2 and 11, the stacked memory device 20 may include a logic die 210 and core dies 220 to 250 that are stacked in the vertical direction VD. The dies 210 to 250 may extend in first and second horizontal directions HD1, HD2. The vertical direction VD may be perpendicular to the horizontal directions HD1, HD2.

According to an embodiment, the refresh cycle may be independently controlled for each unit array UA area. A unit array UA area may refer to an area including one bank. For example, channel areas corresponding to channels CH12, CH13, CH14, and CH15 may be formed in the core die 250, and the channel area corresponding to channel CH12 may include eight unit array UA areas.

A unit array UA area in which a bank whose estimated temperature value higher than the reference temperature thereof is disposed may be controlled with a refresh cycle corresponding to half of (e.g., 0.5 times) the reference refresh cycle. Accordingly, the refresh rate for the bank included in the unit array UA area may be twice (e.g., two times) the reference refresh rate.

A unit array UA area in which a bank whose estimated temperature value lower than the reference temperature thereof is disposed may be controlled with a refresh cycle equal to (e.g., one times) the reference refresh cycle. Accordingly, the refresh rate for the bank included in the unit array UA area may be the same as the reference refresh rate.

However, embodiments are not limited thereto, and the reference temperature may be set to a plurality, and the refresh cycle may be set to various multiples of the reference refresh cycle.

Referring to FIG. 11, because the refresh cycle is independently set for a plurality of banks arranged on one core die, an optimized refresh operation may be performed. Accordingly, improved bandwidth may be provided compared to controlling the refresh rate of all bank arrays based on the hottest portion of one core die.

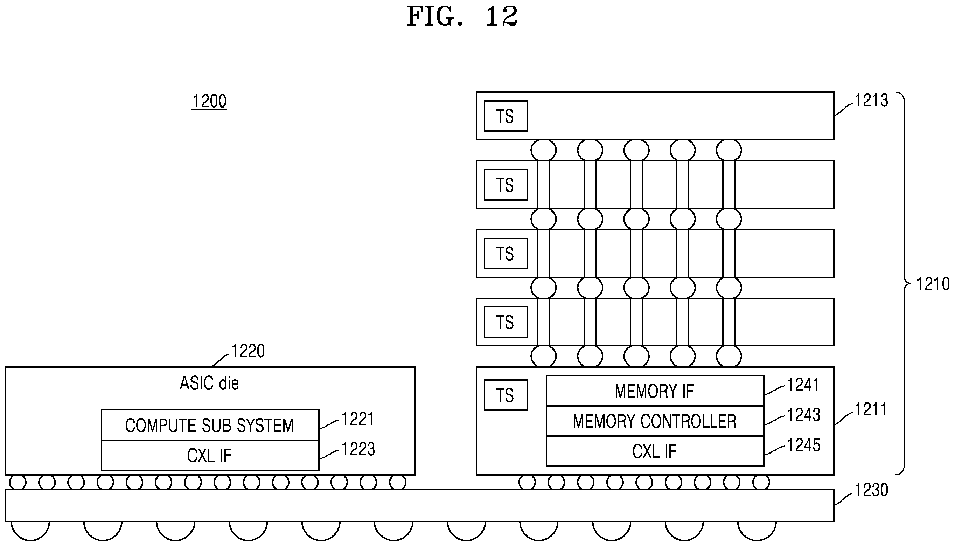

FIG. 12 shows the configuration of a semiconductor device 1200 according to an embodiment.

Referring to FIG. 12, the semiconductor device 1200 may be implemented in forms such as system in package, multi chip package, and system on chip and may be implemented in a package on package form including a plurality of packages.

The semiconductor device 1200 may include a stacked memory device 1210, an application-specific integrated circuit (ASIC) die 1220, and an interposer 1230. The stacked memory device 1210 and the ASIC die 1220 may be connected to an upper portion of the interposer 1230.

The stacked memory device 1210 may correspond to an HBM that increases bandwidth by stacking a plurality of memory chips, for example, a plurality of dies, and electrically connecting the plurality of memory chips through TSV. For example, the stacked memory device 1210 may correspond to stacked memory device 20 of FIG. 2.

The plurality of dies may include a Compute Express Link ("CXL") base die 1211 and a plurality of core dies 1213. Each of the plurality of core dies 1213 may correspond to a DRAM slice die. For example, the plurality of core dies 1213 may include twelve DRAM slice dies.

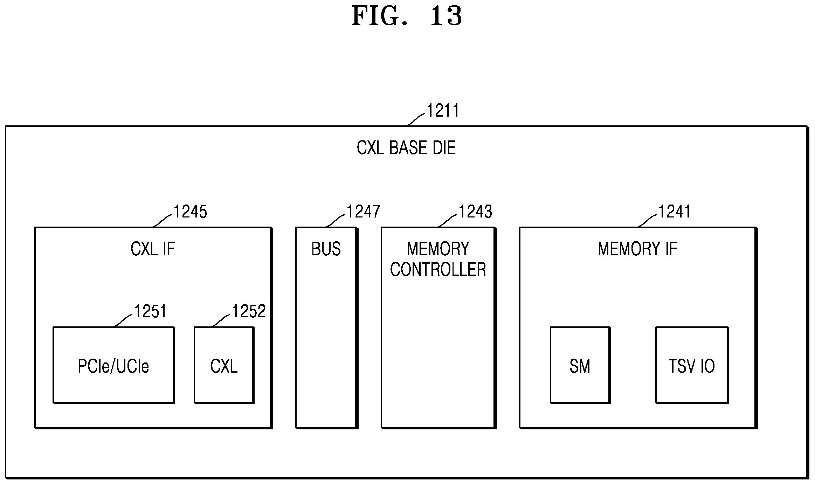

The CXL base die 1211 may include a memory interface 1241 (illustrated as "MEMORY IF"), a memory controller 1243, and a CXL interface circuit 1245 (illustrated as "CXL IF"). An example of the structure of the CXL base die 1211 may be described below in FIG. 13.

The ASIC die 1220 may include a computing subsystem 1221 and a CXL interface 1223 (illustrated as "CXL IF"). The CXL interface 523 of the ASIC die 1220 may be a block that performs the same function as the CXL interface circuit 1245 of the CXL base die 1211. The computing subsystem 1221 may correspond to a system for performing various operations. For example, the computing subsystem 1221 may include at least one of at least one core processing unit (CPU), at least one graphics processing unit (GPU), and at least one neural processing unit (NPU).

In some embodiments, the memory controller 1243 may correspond to the memory controller 411 of FIG. 4. For example, the memory controller 1243 may include the array temperature estimation circuit 413 and the array refresh controller 414 of FIG. 4. In some embodiments, the memory controller 411 of FIG. 4 may be included in the ASIC die 1220. For example, the array temperature estimation circuit 413 and array refresh controller 414 may be included in ASIC die 1220.

FIG. 13 is a block diagram illustrating a CXL base die 1211 according to an embodiment.

Referring to FIG. 13, the CXL base die 1211 may include a memory interface 1241 (illustrated as "MEMORY IF"), a memory controller 1243, a bus 1247, and a CXL interface 1245 (illustrated as "CXL IF"). The memory interface 1241 may be referred to as an HBM interface intellectual property (IP) block.

The memory interface 1241 may include a plurality of input/output circuits for accessing the core die stack. As an example, the memory interface 1241 may include one or more ports for communication with the core die stack. The memory interface 1241 may include a physical or electrical layer and a logical layer that provide for the signals, frequencies, timing, driving, detailed operating parameters, and functionality required for efficient communication between the core die stack and the CXL interface circuit 1245. For example, the memory interface 1241 may directly convert the interface of the HBM core device to a DDR PHY interface (DFI) protocol. For example, when based on the memory interface 1241, conversion for the Joint Electron Device Engineering Council (JEDEC) interface may be bypassed (or skipped). The memory interface 1241 may include a through silicon via (TSV) input/output (IO) block for receiving signals from the core die stack or providing signals to the core die stack and a soft macro (SM) block to convert the output of the TSV IO block to fit the CXL interface circuit 1245. The memory interface 1241 may perform memory interfacing operations, such as selecting rows and columns corresponding to memory cells of the core die stack, writing data to memory cells, or reading written data. In this case, the memory interface 1241 may not support the JEDEC standard. For example, the memory interface 1241 may correspond to a non-JEDEC physical interface (PHY). However, embodiments are not limited thereto, and the memory interface 1241 may support the JEDEC standard.

The memory controller 1243 may control overall operation of the CXL base die 1211 and the core die stack. For example, the memory controller 1243 may receive the output of the memory interface 1241 and provide read data to the CXL interface circuit 1245 through the bus 1247, or receive the output of the CXL interface circuit 1245 through the bus 1247 and provide write data to the core die stack through the memory interface 1241.

The CXL interface circuit 1245 may include a CXL block 1252 and a communication interface block 1251. For example, the communication interface block 1251 may support communication interfaces such as peripheral component interconnect express (PCIe) and universal chiplet interconnect express (UCIe).

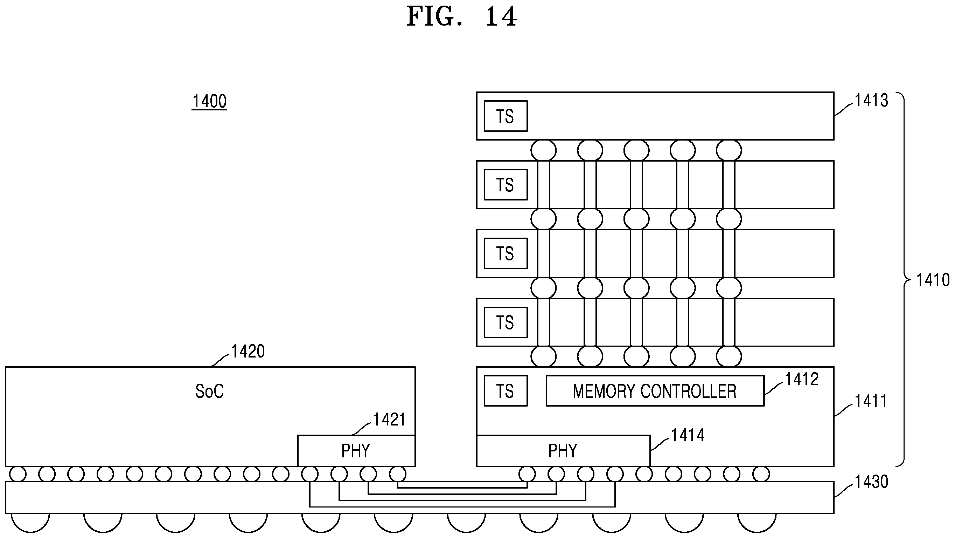

FIG. 14 is a diagram illustrating a stacked memory device according to an embodiment.

Referring to FIG. 14, a semiconductor device 1400 may include a stacked memory device 1410, a SoC 1420, and an interposer 1430.

The stacked memory device 1410 may correspond to an HBM that increases bandwidth by stacking a plurality of memory chips, for example, a plurality of dies, and electrically connecting the plurality of memory chips to each other through a TSV. For example, the stacked memory device 1210 may correspond to the stacked memory device 200 of FIG. 2.

The plurality of dies may include a logic die 1411 and a plurality of core dies 1413. Each of the plurality of core dies 1413 may correspond to a DRAM slice die. For example, the plurality of core dies 1413 may include twelve DRAM slice dies.

The logic die 1411 may communicate with a device (e.g., the SoC 1420) located outside the stacked memory device 1410. The logic die 1411 may transmit the address and data transmitted from the SoC 1420 to the plurality of core dies 1413 and receive data from the plurality of core dies 1413. The logic die 1411 may provide an interface between the plurality of core dies 1413 and the SoC 1420. The logic die 1411 may include a physical layer PHY 1414 electrically connected to the SoC 1420. Here, the logic die 1411 may be referred to as an interface die, master die, buffer die, etc. The logic die 1411 may include a memory controller 1412. The memory controller 1412 may correspond to the memory controller 411 of FIG. 4. In some embodiments, the memory controller 1412 may be included in SoC 1420. That is, the memory controller 1412 included in the SoC 1420 may receive temperature values from a temperature sensor TS included in the plurality of core dies 1413 and the logic die 1411 and estimate temperature values corresponding to a plurality of bank arrays included in a plurality of core dies 1413 based on the received temperature values. The memory controller 1412 may independently adjust the refresh cycle of each of the plurality of bank arrays based on the estimated temperature value.

In an embodiment, the stacked memory device 1410 may be a general-purpose DRAM device, such as double data rate (DDR) synchronous dynamic random access memory (SDRAM), DDR2 SDRAM, DDR3 SDRAM, DDR4 SDRAM, and DDR5 SDRAM. The stacked memory device 1410 may be a mobile DRAM device, such as low power double data rate (LPDDR) SDRAM, LPDDR2 SDRAM, LPDDR3 SDRAM, LPDDR4 SDRAM, LPDDR4X, SDRAM, and LPDDR5 SDRAM. The stacked memory device 1410 may be a graphics DRAM device, such as graphics double data rate (GDDR) synchronous graphics random access memory (SGRAM), GDDR2 SGRAM, GDDR3 SGRAM, GDDR4 SGRAM, GDDR5, SGRAM, GDDR6 SGRAM. The stacked memory device 1410 may be a memory device, such as wide I/O, high bandwidth memory (HBM), HBM2, HBM3, hybrid memory cube (HMC) that provides high capacity and high bandwidth.

The SoC 1420 may include a processor capable of performing various operations for applications supported by the semiconductor device 1400. For example, the SoC 1402 may include at least one of a central processing unit (CPU), an image signal processing unit (ISP), a digital signal processing unit (DSP), a graphics processing unit (GPU), a vision processing unit (VPU), and a neural processing unit (NPU). The SoC 1420 may include a physical layer PHY, 1421 electrically connected to the logic die 1411. The SoC 1420 may store data required for computation in the stacked memory device 1410 or read data required for computation from the stacked memory device 1410.

The physical layers 1414 and 1421 may support at least one communication interface. For example, the physical layers 1414 and 1421 may support communication interfaces that complies with the peripheral component interconnect express (PCIe), universal chiplet interconnect express (UCIe), or JEDEC standards.

The interposer 1430 may connect the stacked memory device 1410 to the SoC 1420. In more detail, the interposer 1430 may connect the stacked memory device 1410 to the SoC 1420 and provide physical paths formed using conductive materials for electrical connection between the stacked memory device 1410 and the SoC 1420. For example, the interposer 1430 may be a silicon interposer.

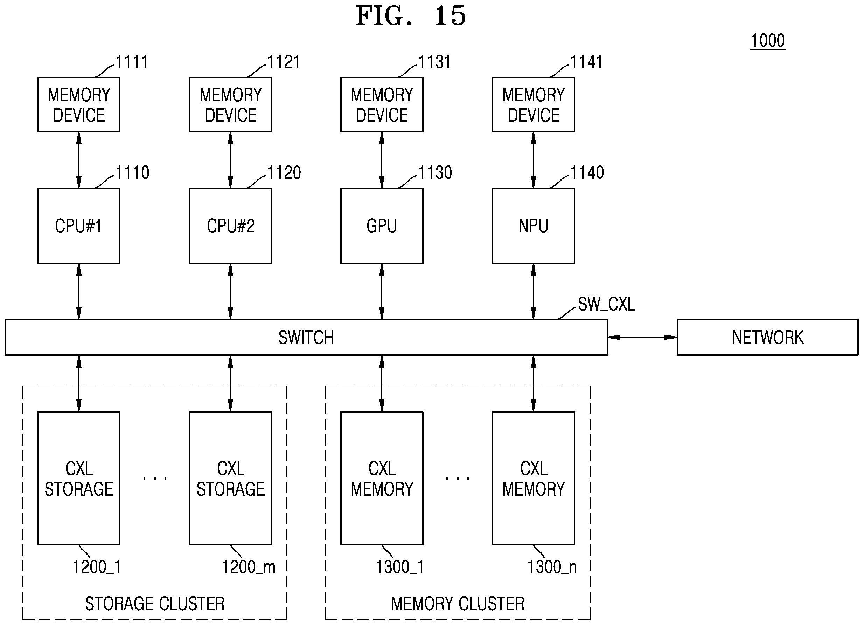

FIG. 15 is a block diagram showing a computing system according to an embodiment.

Referring to FIG. 15, a computing system 1000 may include a first CPU 1110, a second CPU 1120, a GPU 1130, an NPU 1140, a CXL switch SW_CXL, a plurality of memory devices, for example a memory device 1111, a memory device 1121, a memory device 1131, and a memory device 1141, a plurality of CXL storages, for example a CXL storage 1200_1 through a CXL storage 1200_m, and a plurality of CXL memories, for example a CXL memory 1300_1 through a CXL memory 1300_n.

The first CPU 1110, the second CPU 1120, the GPU 1130, and the NPU 1140 may be directly connected to a plurality of memory devices 1111, 1121, 1131, and 1141, respectively.

The first CPU 1110, the second CPU 1120, the GPU 1130, the NPU 1140, the plurality of CXL storages 1200_1 to 1200_m, and the plurality of CXL memories 1300_1 to 1300_n may be commonly connected to the CXL switch SW_CXL, and each may communicate with each other through the CXL switch SW_CXL.

In some embodiments, the first CPU 1110, the second CPU 1120, the GPU 1130, and the NPU 1140 may each manage a plurality of CXL storages 1200_1 to 1200_m as one storage cluster, and manage a plurality of CXL memories 1300_1 to 1300_n as one memory cluster.

In some embodiments, each of the plurality of CXL memories 1300_1 to 1300_m may be the memory system 10 of FIG. 1.

In some embodiments, the CXL switch SW_CXL may be connected to an external network or fabric, and may be configured to communicate with an external server through the external network or fabric.

In some embodiments, the memory controller 411 of FIG. 4, for example the array temperature estimation circuit 413 and the array refresh controller 414, may be included in the CXL memories 1300_1 to 1300_m.

In some embodiments, the memory controller 411 of FIG. 4, for example the array temperature estimation circuit 413 and the array refresh controller 414, may be included in a first CPU 1110, a second CPU 1120, a GPU 1130, an NPU 1140, a plurality of CXL storages 1200_1 to 1200_m, or a plurality of memory devices 1111, 1121, 1131, and 1141. Accordingly, the refresh operation of the CXL memories 1300_1 to 1300_m may be controlled by another master IP block or another slave IP block.

While some embodiments are shown and described above, it will be understood that various changes in form and details may be made therein without departing from the scope of the following claims.

## Claims

1. A memory device comprising:
a plurality of core dies, wherein each core die of the plurality of core dies comprises a plurality of channel areas including a plurality of bank arrays, and wherein the plurality of core dies are stacked in a vertical direction; and
a logic die below the plurality of core dies, wherein the logic die comprises a memory controller and at least one temperature sensor, wherein the memory controller is configured to transmit data to the plurality of channel areas and to receive data from the plurality of channel areas using a plurality of channels,
wherein the memory controller is configured to independently adjust refresh cycles of the plurality of bank arrays based on temperature values obtained from a plurality of first temperature sensors included in the plurality of channel areas and a second temperature sensor included in the logic die.

2. The memory controller of claim 1, wherein the memory controller is further configured to estimate a temperature of each bank array of the plurality of bank arrays based on the temperature values, and to adjust a refresh cycle of the each bank array based on the estimated temperature.

3. The memory controller of claim 2, wherein the memory controller is further configured to:
update, to a first cycle, refresh cycles of first bank arrays of corresponding to first estimated temperature values that are greater than or equal to a reference temperature value, wherein the first bank arrays are included in a first core die from among the plurality of core dies, and
update, to a second cycle, refresh cycles of second bank arrays corresponding to second estimated temperature values that are less than the reference temperature value, wherein the second bank arrays are included in the first core die.

4. The memory controller of any preceding claim, wherein channel areas including the plurality of first temperature sensors are arranged alternatingly in the vertical direction.

5. The memory controller of claim 4, wherein a first temperature sensor is included in a first channel area from among channel areas included in a first core die from among the plurality of core dies,
wherein a bank array is included in a second channel area that is vertically adjacent to the first channel area from among channel areas included in a second core die that is vertically adjacent to the first core die, and
wherein the memory controller is further configured to estimate a second temperature value corresponding to the bank array based on a first temperature value corresponding to the first temperature sensor.

6. The memory controller of any preceding claim, wherein a lowest core die among the plurality of core dies comprises a first channel area including a first temperature sensor from among the plurality of first temperature sensors,
wherein the second temperature sensor is included in a second channel area within the logic die, and
wherein the first channel area does not overlap the second channel area in the vertical direction.

7. The memory controller of any of claims 1 to 5, wherein a bank array is included in a channel area from among channel areas of a lowest core die from among the plurality of core dies,
wherein the channel area vertically overlaps an area including the second temperature sensor within the logic die, and
wherein the memory controller is further configured to estimate a temperature value corresponding to the bank array based on a temperature value corresponding to the second temperature sensor.

8. The memory controller of any preceding claim, wherein the memory controller is further configured to:
based on a number of the plurality of bank arrays being less than a number of plurality of the first temperature sensors and the second temperature sensor, estimate a temperature value corresponding to at least one bank array included in a first channel area, based on a temperature value corresponding to a first temperature sensor included in a second channel area that is horizontally adjacent to the first channel area.

9. The memory controller of claim 8, wherein the memory controller is further configured to estimate the temperature value corresponding to the at least one bank array by averaging temperature values corresponding to some first temperature sensors from among the plurality of first temperature sensors, and
wherein the some first temperature sensors are included in a plurality of channel areas adjacent to the first channel area.

10. An operation method of a memory device, the method comprising:
obtaining a plurality of first temperature values from a plurality of first temperature sensors included in a plurality of vertically stacked core dies;
obtaining a second temperature value from a second temperature sensor included in a logic die below the plurality of core dies;
estimating temperature values corresponding to a plurality of bank arrays included in the plurality of core dies, based on the plurality of first temperature values and the second temperature value; and
based on the estimated temperature values, independently updating refresh cycles of a plurality of bank arrays included in each core die from among the plurality of core dies.

11. The method of claim 10, further comprising,
based on the plurality of first temperature sensors and the second temperature sensor being respectively assigned to all bank arrays of the plurality of bank arrays, estimating the temperature values based on the obtained plurality of first temperature values and the second temperature value.

12. The method of claim 10, further comprising, based on the plurality of first temperature sensors and the second temperature sensor being assigned to some bank arrays included in the plurality of core dies:
estimating a temperature value for each bank array of the some bank arrays based on a corresponding temperature sensor; and
estimating a temperature value for each bank array of remaining bank arrays from among the plurality of bank arrays based on a temperature sensor included in a second channel area that is horizontally adjacent to a first channel area including the remaining bank arrays.

13. The method of claim 10, further comprising, based on the plurality of first temperature sensors and the second temperature sensor being assigned to some bank arrays included in the plurality of core dies:
for each bank array of the some bank arrays, estimating a temperature value based on a corresponding temperature sensor; and
estimating a temperature value for each bank array of remaining bank arrays from among the plurality of bank arrays based on a temperature sensor included in a second core die that is vertically adjacent to a first core die including the remaining bank arrays.

14. The method of claim 13, wherein the temperature sensor included in the second core die is included in a second channel area that is vertically adjacent to a first channel area including the remaining bank arrays among channel areas included in the second core die.

15. A semiconductor device comprising:
an interposer comprising conductive materials;
a stacked memory device on the interposer, wherein the stacked memory device comprises a plurality of core dies and a buffer die, wherein the plurality of core dies comprises a plurality of bank arrays and a plurality of first temperature sensors, and wherein the buffer die comprises a first interface circuit and a second temperature sensor; and
a system-on-chip on the interposer, wherein the system-on-chip comprises a second interface circuit and a memory controller, wherein the second interface circuit is configured to communicate with the first interface circuit through the conductive materials, and wherein the memory controller is configured to control the plurality of core dies,
wherein the memory controller is further configured to independently adjust refresh cycles of the plurality of bank arrays included in the plurality of core dies based on temperature values obtained from the plurality of first temperature sensors and the second temperature sensor.
